Europäisches Patentamt

European Patent Office

Office européen des brevets

(19)

(11) EP 0 716 748 B1

(12) **EUROPÄISCHE PATENTSCHRIFT**

(45) Veröffentlichungstag und Bekanntmachung des Hinweises auf die Patenterteilung:
**07.01.1998 Patentblatt 1998/02**

(21) Anmeldenummer: **94922822.5**

(22) Anmeldetag: **15.07.1994**

(51) Int Cl.6: **G01R 19/25**

(86) Internationale Anmeldenummer:
**PCT/DE94/00873**

(87) Internationale Veröffentlichungsnummer:
**WO 95/06880 (09.03.1995 Gazette 1995/11)**

(54) **DIGITALES VERFAHREN ZUM ERMITTELN EINER MESSGRÖSSE AUS EINEM ELEKTRISCHEN SIGNAL**

DIGITAL PROCESS FOR FINDING A MEASURED QUANTITY FROM AN ELECTRIC SIGNAL

PROCEDE NUMERIQUE DE DETERMINATION D'UNE GRANDEUR A MESURER A PARTIR D'UN SIGNAL ELECTRIQUE

(84) Benannte Vertragsstaaten:
**AT CH DE FR GB LI SE**

(30) Priorität: **31.08.1993 DE 4330179**

(43) Veröffentlichungstag der Anmeldung:
**19.06.1996 Patentblatt 1996/25**

(73) Patentinhaber: **SIEMENS AKTIENGESELLSCHAFT**
**80333 München (DE)**

(72) Erfinder: **SEZI, Tevfik**
**D-12169 Berlin (DE)**

(56) Entgegenhaltungen:
**DE-A- 4 122 399          DE-A- 4 205 300**

- **INTERNATIONAL JOURNAL OF ELECTRONICS, Bd.59, Nr.2, August 1985, LONDON,GB Seiten 199 - 210 TAHA ET AL. 'direct digital RMS measuring device'**

**Beschreibung**

Die Erfindung bezieht sich auf ein digitales Verfahren zum Ermitteln einer Meßgröße aus einem elektrischen Signal mit vorgegebener Nennfrequenz, bei dem

- das elektrische Signal in einer Abtasteinrichtung unter Gewinnung von Abtastwerten mit einer mittels eines Taktgenerators erzeugten Abtastfrequenz abgetastet wird, die dem N-fachen der Nennfrequenz des elektrischen Signals entspricht,
- die abgetasteten Werte in einem Analog-Digital-Wandler in digitale Werte umgesetzt werden und
- aus den digitalen Werten in einer Auswerteeinrichtung die Meßgröße gewonnen wird.

Ein derartiges Verfahren ist beispielsweise in dem Buch von P. Profos und T. Pfeifer "Handbuch der industriellen Meßtechnik", 1992, Seiten 404 und 405 beschrieben. Bei diesem bekannten Verfahren wird unter anderem zur Effektivwertmessung ein von einer elektrischen Spannung mit vorgegebener Frequenz gebildetes elektrisches Signal abgetastet und analog-digital gewandelt; in einer Auswerteeinrichtung wird daraus der Effektivwert der Spannung berechnet. Auch der Effektivwert eines Stromes sowie die elektrische Leistung können mit dem bekannten Verfahren ermittelt werden.

Weitere bekannte Verfahren der eingangs angegebenen Art lassen sich dem Buch von R. Felderhoff "Elektrische und elektronische Meßtechnik", 5. Auflage, 1990, Seiten 307 bis 311 und dem Buch von R. Lappe und F. Fischer "Leistungselektronik-Meßtechnik", 2. Auflage, 1993, Seite 242 entnehmen.

Die Frequenz-Messung kann im einzelnen so ausgeführt werden, wie es in dem Aufsatz von J. Heydeman und E.N. Lulf "Microprozessor Based Underfrequency Relaying", Delft University of Technology, the Netherlands, veröffentlicht in IEE Conference Publication No. 249, Third Internal Conference on Developments in Power-System Protection, 1985, Seiten 24 bis 28 beschrieben ist. Die Spannung wird dabei mit einer Frequenz von 2,5 kHz abgetastet, was dadurch erreicht ist, daß der Mikroprozessor so programmiert ist, daß er Interrupts mit dieser Frequenz erzeugt. Der Nulldurchgang der Spannung wird softwaremäßig erfaßt; aus der Anzahl während einer Periode der Spannung gezahlter Impulse kann dann die Frequenz der Spannung errechnet werden, indem der Quotient aus der Abtastfrequenz und der Impulsanzahl pro Periode gebildet wird. Die Genauigkeit dieses bekannten Verfahrens zur Frequenzmessung ist einerseits bestimmt durch die erzielbare Genauigkeit bei der Erfassung der Periodenlänge und andererseits durch die Höhe der Abtastfrequenz.

Der Erfindung liegt die Aufgabe zugrunde, ein digitales Verfahren zum Ermitteln einer Meßgröße aus einem elektrischen Signal anzugeben, mit dem sich die Meßgröße ohne wesentliche Erhöhung des Aufwandes und ohne Verlängerung der Auswertungszeit wesentlich genauer als mit den oben beschriebenen bekannten Verfahren ermitteln läßt.

Zur Lösung dieser Aufgabe wird bei einem digitalen Verfahren der eingangs angegebenen Art erfindungsgemäß

- mit einer Frequenz-Meßeinrichtung ein Meßwert ermittelt, der der momentanen Frequenz des elektrischen Signals entspricht,
- der Meßwert mit dem Faktor N unter Erzeugen eines abgeleiteten Meßwertes multipliziert,
- in einem Quotientenbildner eine dem Quotienten aus der Taktfrequenz des Taktgenerators und dem abgeleiteten Meßwert entsprechende Zwischengröße gebildet und
- mit der Zwischengröße das Teilerverhältnis eines zwischen dem Taktgenerator und dem Takteingang des Analog-Digital-Wandlers angeordneten Frequenzteilers derart eingestellt, daß dem Takteingang die dem abgeleiteten Meßwert entsprechende Frequenz zugeführt wird, wobei
- eine Änderung des Teilerverhältnisses jeweils frühestens nach Ablauf einiger Perioden des elektrischen Signals vorgenommen wird.

Es ist zwar aus der DE-A-41 22 399 bekannt, bei einem Verfahren zum digitalen Messen von Spannungen und Strömen in einem Energieversorgungssystem die Abtastfrequenz aus der momentanen Frequenz der jeweils untersuchten Wechselgröße abzuleiten, um relativ genau messen zu können, jedoch enthält diese Druckschrift keinen Hinweis auf einen Taktgenerator und einen diesem nachgeordneten Quotientenbildner, der außerdem mit einer aus der momentanen Frequenz des untersuchten elektrischen Signals abgeleiteten Meßgröße beaufschlagt ist.

Der wesentliche Vorteil des erfindungsgemäßen Verfahrens besteht darin, daß bei ihm unabhängig von der jeweiligen momentanen Frequenz des untersuchten analogen elektrischen Signals mit einer Abtastfrequenz gearbeitet wird, die dem N-fachen der momentanen Frequenz des elektrischen Signals entspricht. Dadurch ist die Meßgenauigkeit wesentlich erhöht, weil auch bei Frequenzen des elektrischen Signals, die von der Nennfrequenz abweichen, pro Periode des elektrischen Signals stets eine gleichgroße Anzahl von Abtastungen vorgenommen wird. Bei dem erfindungsgemäßen Verfahren wird also die Abtastfrequenz der jeweils ermittelten Frequenz des elektrischen Signals angepaßt. Diese geschieht mit einer hohen Genauigkeit, da in dem Quotientenbildner eine dem Quotienten aus der Taktfrequenz des Taktgenerators und dem abgeleiteten Meßwert entsprechende Zwischengröße gebildet wird. Es ist somit sichergestellt, daß die Abtastfrequenz stets neu aus der Taktfrequenz des Taktgenerators abgeleitet wird.

Bei dem erfindungsgemäßen Verfahren ist wegen der erzielbaren hohen Genauigkeit der Frequenz-Messung vorteilhafterweise die Frequenz-Meßeinrichtung eine digitale Frequenzmeßeinrichtung.

Die Frequenz-Messung kann im einzelnen so ausgeführt werden, wie es in dem Aufsatz von J. Heydeman und E.N. Lulf "Microprozessor Based Underfrequency Relaying", Delft University of Technology, the Netherlands, veröffentlicht in IEE Conference Publication No. 249, Third Internal Conference on Developments in Power-System Protection, 1985, Seiten 24 bis 28 beschrieben ist. Die Spannung wird dabei mit einer Frequenz von 2,5 kHz abgetastet, was dadurch erreicht ist, daß der Mikroprozessor so programmiert ist, daß er Interrupts mit dieser Frequenz erzeugt. Der Nulldurchgang der Spannung wird softwaremäßig erfaßt; aus der Anzahl während einer Periode der Spannung gezählter Impulse kann dann die Frequenz der Spannung errechnet werden, indem der Quotient aus der Abtastfrequenz und der Impulsanzahl pro Periode gebildet wird. Die Genauigkeit dieses bekannten Verfahrens zur Frequenzmessung ist einerseits bestimmt durch die erzielbare Genauigkeit bei der Erfassung der Periodenlänge und andererseits durch die Höhe der Abtastfrequenz.

Besonders genau läßt sich die Frequenz des elektrischen Signals mit einem Verfahren bestimmen, bei dem die digitale Frequenz-Meßeinrichtung als ein mit dem elektrischen Signal beaufschlagtes linearphasiges, nichtrekursives Digitalfilter mit symmetrischer Verteilung seiner Filterkoeffizienten als ein Allpaßfilter ausgebildet ist, ein ebenfalls mit dem elektrischen Signal beaufschlagtes weiteres linearphasiges, nichtrekursives Digitalfilter mit symmetrischer Verteilung seiner Filterkoeffizienten als ein Tiefpaßfilter derart ausgestaltet ist, daß seine Übertragungsfunktion bei einer vorgegebenen Frequenz des elektrischen Signals den Wert Eins aufweist, dem Allpaßfilter eine Schaltseinheit nachgeordnet ist, die in einem Zweig eingangsseitig ein linearphasiges Transversalfilter mit symmetrischer Verteilungseiner Filterkoeffizienten ein diesem nachgeschaltetes Verzögerungsglied und einen nachgeordneten Multiplizierer enthält und in einem zu dem einen Zweig parallelen Zweig eingangsseitig ein weiteres linearphasiges Transversalfilter mit antisymmetrischer Verteilung seiner Filterkoeffizienten und einem Wert Eins seiner Übertragungsfunktion bei der vorgegebenen Frequenz, ein diesem nachgeschaltetes weiteres Verzögerungsglied und einen nachgeordneten weiteren Multiplizierer aufweist, wobei der eine Multiplizierer eingangsseitig auch mit einem Ausgang des weiteren Transversalfilters und der weitere Multiplizierer auch mit dem Ausgang des einen Transversalfilters verbunden ist, und einen Differenzbildner enthält, der mit seinen Eingängen mit den Ausgängen der Multiplizierer verbunden ist; dem Tiefpaßfilter ist eine im Aufbau der Schal-tungseinheit identische Schaltungseinrichtung nachgeordnet und die Ausgänge der Differenzbildner der Schal-tungseinheit und der Schaltungseinrichtung sind mit einem Quotientenbildner verbunden, dem ein Radizierer nachgeordnet ist, und an den Radizierer ist ein Umkehrfunktionsbildner angeschlossen. Weitere Einzelheiten und Vorteile dieser Art der Frequenz-Messung lassen sich der älteren deutschen Patentanmeldung P 42 11 946.4 oder der korrespondierenden internationalen Anmeldung PCT/DE/93/00262 entnehmen.

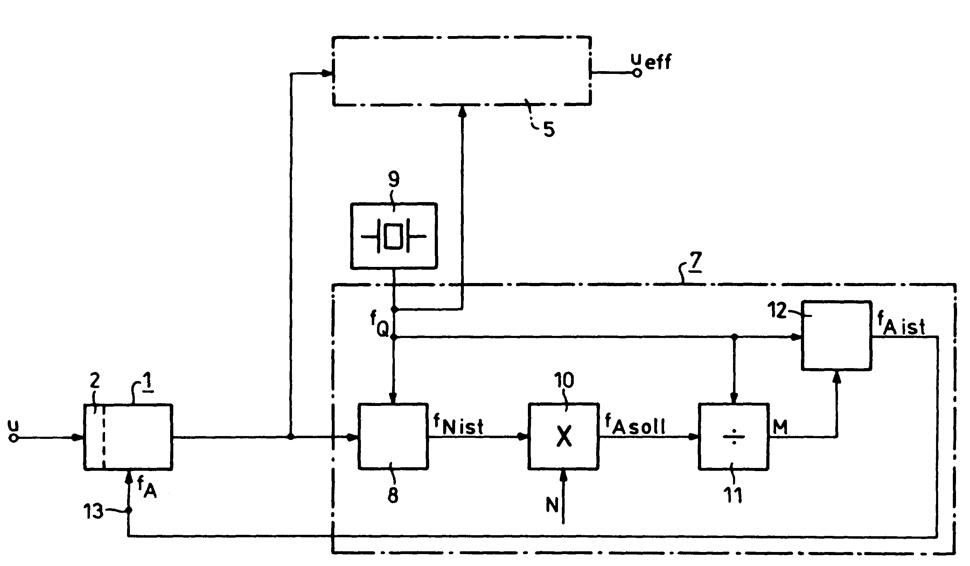

Zur Erläuterung der Erfindung ist in der Figur in Form eines Blockschaltbildes eine Anordnung dargestellt, die zur Durchführung des erfindungsgemäßen digitalen Verfahrens geeignet ist. Dieses Blockschaltbild dient vor allem zur Veranschaulichung des erfindungsgemäßen Verfahrens; in der Praxis wird das erfindungsgemäße Verfahren nämlich bevorzugt mit einem Mikroprozessor durchgeführt.

Wie die Figur erkennen läßt, wird ein analoges elektrisches Signal u, beispielsweise die Spannung eines nicht dargestellten elektrischen Energieversorgungsnetzes, einem Analog-Digital-Wandler 1 zugeführt, der eingangsseitig eine Abtasteinrichtung 2 integriert enthält. Dem Analog-Digital-Wandler 1 ist eine Auswerteeinrichtung 5 zur Bestimmung des Effektivwertes $u_{eff}$ der Spannung u nachgeordnet. An den Ausgang des Analog-Digital-Wandlers 1 ist ferner ein Abtastsignal-Geber 7 angeschlossen, der eingangsseitig eine digitale Frequenz-Meßeinrichtung 8 aufweist. Die abgetasteten, digitalen Werte des elektrischen Signals u werden von der nachgeordneten digitalen Frequenz-Meßeinrichtung 8 aufgenommen, die beispielsweise so ausgeführt sein kann und so arbeiten kann, wie es in dem oben erwähnten Aufsatz im einzelnen beschrieben ist. Bevorzugt wird als Frequenz-Meßeinrichtung jedoch eine Anordnung, wie sie in der älteren deutschen Patentanmeldung P 42 11 946.4-35 oder der korrespondierenden internationalen Anmeldung PCT/DE 93/00262 erläutert ist. Der digitalen Frequenz-Meßeinrichtung 8 - wie auch der Auswerteeinrichtung 5 - ist ein Taktgeber 9 zugeordnet, der eine Taktfrequenz $f_Q$ an die digitale Frequenz-Meßeinrichtung 8 abgibt. Am Ausgang der digitalen Frequenz-Meßeinrichtung 8 ergibt sich dann ein Meßwert $f_{Nist}$, der die momentane Frequenz des Signals u angibt.

Der Meßwert $f_{Nist}$ wird einem Multiplizierer 10 zugeführt, in dem eine Multiplikation mit einem Faktor N erfolgt. Dieser Faktor N gibt das Verhältnis der Abtastfrequenz $f_A$ zur Nennfrequenz des analogen elektrischen Signals u an. Bei einer Spannung in einem elektrischen Energieversorgungsnetz als analoges elektrisches Signal u beträgt die Nennfrequenz beispielsweise 50 Hz; sie entspricht der Netznennfrequenz. Die Abtastfrequenz $f_A$ ist beispielsweise zu 1 kHz gewählt, so daß der Faktor N den Wert 20 aufweist.

Am Ausgang des Multiplizierers 10 entsteht ein abgeleiteter Meßwert $f_{Asoll}$, der eine Abtast-Sollfrequenz angibt; bei dem oben gewählten Zahlenbeispiel beträgt diese Frequenz in dem Falle, in dem die Spannung u die Frequenz von genau 50 Hz hat, also 1 kHz. Ist dagegen die momentane Frequenz am Ausgang der digitalen Frequenz-Meßeinrichtung z.B. zu 49,5 Hz ermittelt, beträgt also der Meßwert $f_{Nist}$ = 49,5 Hz, dann wird eine Abtast-Sollfrequenz von 990 Hz errechnet, weil der abgeleitete Meßwert $f_{Asoll}$ = N . $f_{Nist}$. Der abgeleitete, Meßwert $f_{Asoll}$ wird einem nachgeordneten Quotientenbildner 11 zugeführt, der auch noch mit der Taktfrequenz $f_Q$ des Taktgenerators 9 beaufschlagt ist. Am Ausgang des Quotientenbildners 11 entsteht dann eine Zwischengröße M, die sich durch folgende Beziehung beschreiben läßt,

$$f_Q / f_{Asoll} = M$$

Mit dieser Zwischengröße M wird das Teilerverhältnis eines nachgeordneten Frequenzteilers 12 verändert, der mit einem weiteren Eingang unmittelbar mit dem Taktgenerator 9 verbunden ist. Am Ausgang des Frequenzteilers 12 entsteht somit ein Signal mit einer Frequenz $f_{Aist}$, die sich durch folgende Gleichung beschreiben läßt

$$f_{Aist} = f_Q \cdot (f_{Asoll} / f_Q)$$

Die Frequenz $f_{Aist}$ entspricht daher der Abtast-Sollfrequenz, wodurch sichergestellt ist, daß der Analog-Digital-Wandler 1 stets mit einer solchen Frequenz $f_A$ getaktet wird, die genau dem N-fachen der jeweiligen momentanen Frequenz des elektrischen Signals u entspricht. Der Ausgang des Frequenzteilers 12 ist nämlich mit einem Takteingang 13 des Analog-Digital-Wandlers 1 verbunden.

Um die Arbeitsweise des dargestellten Verfahrens stabil zu halten, wird die Beaufschlagung des Analog-Digital-Wandlers 1 mit jeweils einer neu angepaßten Abtastfrequenz nicht sofort auf eine Änderung des Meßwertes $f_{Nist}$ vorgenommen, sondern es wird in nicht dargestellter Weise eine Verzögerung durchgeführt, die beispielsweise in der Größenordnung von 4 Perioden des elektrischen Signals u liegen kann. Erst nach Ablauf von 4 Perioden des Signals u wirkt sich also eine Änderung des Meßwertes $f_{Nist}$ auf die Abtastfrequenz $f_A$ aus.

## Patentansprüche

1. Digitales Verfahren zum Ermitteln einer Meßgröße aus einem elektrischen Signal (u) mit vorgegebener Nennfrequenz, bei dem

  - das elektrische Signal (u) in einer Abtasteinrichtung (2) unter Gewinnung von Abtastwerten mit einer mittels eines Taktgenerators (9) erzeugten Abtastfrequenz ($f_A$) abgetastet wird, die dem N-fachen der Nennfrequenz des elektrischen Signals (u) entspricht,
  - die abgetasteten Werte in einem Analog-Digital-Wandler (1) in digitale Werte umgesetzt werden und
  - aus den digitalen Werten in einer Auswerteeinrichtung (5) die Meßgröße gewonnen wird,

**dadurch gekennzeichnet**, daß

  - mit einer Frequenz-Meßeinrichtung (8) ein Meßwert ($f_{Nist}$) ermittelt wird, der der momentanen Frequenz des elektrischen Signals (u) entspricht,
  - der Meßwert ($f_{Nist}$) mit dem Faktor N unter Erzeugen eines abgeleiteten Meßwertes ($f_{Asoll}$) multipliziert wird,
  - in einem Quotientenbildner (11) eine dem Quotienten aus der Taktfrequenz ($f_Q$) des Taktgenerators (9) und dem abgeleiteten Meßwert ($f_{Asoll}$) entsprechende Zwischengröße (M) gebildet wird und
  - mit der Zwischengröße (M) das Teilerverhältnis eines zwischen dem Taktgenerator (9) und dem Takteingang des Analog-Digital-Wandlers (1) angeordneten Frequenzteilers (12) derart eingestellt wird, daß dem Takteingang die dem abgeleiteten Meßwert ($f_{Asoll}$) entsprechende Frequenz ($f_A$) zugeführt wird, wobei
  - eine Änderung des Teilerverhältnisses jeweils frühestens nach Ablauf einiger Perioden des elektrischen Signals ($u_k$) vorgenommen wird.

2. Verfahren nach Anspruch 1 oder 2,
   **dadurch gekennzeichnet**, daß

  - die Frequenz-Meßeinrichtung eine digitale Frequenzmeßeinrichtung ist.

3. Verfahren nach Anspruch 2,
   **dadurch gekennzeichnet**, daß

  - bei der digitalen Frequenz-Meßeinrichtung (8) ein mit dem elektrischen Signal beaufschlagtes linearphasiges, nichtrekursives Digitalfilter mit symmetrischer Verteilung seiner Filterkoeffizienten als ein Allpaßfilter ausgebildet ist,
  - ein ebenfalls mit dem elektrischen Signal beaufschlagtes weiteres linearphasiges, nichtrekursives Digitalfilter mit symmetrischer Verteilung seiner Filterkoeffizienten als ein Tiefpaßfilter derart ausgestaltet ist, daß seine Übertragungsfunktion bei einer vorgegebenen Frequenz des elektrischen Signals den Wert Eins aufweist,
  - dem Allpaßfilter eine Schalteinheit nachgeordnet ist, die

    - in einem Zweig eingangsseitig ein linearphasiges Transversalfilter mit symmetrischer Verteilung seiner Filterkoeffizienten, ein diesem nachgeschaltetes Verzögerungsglied und einen nachgeordneten Multiplizierer enthält und

- in einem zu dem einen Zweig parallelen Zweig eingangsseitig ein weiteres linearphasiges Transversalfilter mit antisymmetrischer Verteilung seiner Filterkoeffizienten und einem Wert Eins seiner Übertragungsfunktion bei der vorgegebenen Frequenz, ein diesem nachgeschaltetes weiteres Verzögerungsglied und einen nachgeordneten weiteren Multiplizierer aufweist, wobei

  - der eine Multiplizierer eingangsseitig auch mit einem Ausgang des weiteren Transversalfilters und der weitere Multiplizierer auch mit dem Ausgang des einen Transversalfilters verbunden ist, und
  - einen Differenzbildner enthält, der mit seinen Eingängen mit den Ausgängen der Multiplizierer verbunden ist,

- dem Tiefpaßfilter eine im Aufbau mit der Schaltungseinheit identische Schaltungseinrichtung nachgeordnet ist,
- die Ausgänge der Differenzbildner der Schaltungseinheit und der Schaltungseinrichtung mit einem Quotientenbildner verbunden sind, dem ein Radizierer nachgeordnet ist, und
- an den Radizierer ein Umkehrfunktionsbildner angeschlossen ist.

## Claims

1. Digital method for establishing a measured variable from an electrical signal (u) having a predetermined nominal frequency, in which method

   - in a sampling device (2), obtaining sampled values, the electrical signal (u) is sampled with a sampling frequency ($f_A$) which is generated by means of a clock generator (9) and corresponds to the N-fold of the nominal frequency of the electrical signal (u),
   - the sampled values are converted into digital values in an analog-to-digital converter (1), and
   - the measured variable is obtained from the digital values in an evaluation device (5),

   characterised in that

   - a measured value ($f_{Nist}$) which corresponds to the instantaneous frequency of the electrical signal (u) is established with a frequency-measuring device (8),
   - the measured value ($f_{Nist}$) is multiplied by the factor N, generating a derived measured value ($f_{Asoll}$),

- an intermediate variable (M) which corresponds to the quotient of the clock frequency ($f_Q$) of the clock generator (9) and the derived measured value ($f_{Asoll}$) is formed in a quotient former (11), and
- with the intermediate variable (M), the divider ratio of a frequency divider (12) arranged between the clock generator (9) and the clock input of the analog-to-digital converter (1) is adjusted in such a way that the frequency ($f_A$) which corresponds to the derived measured value ($f_{Asoll}$) is supplied to the clock input, wherein
- an alteration of the divider ratio is carried out in each case at the earliest after the end of several periods of the electrical signal ($u_k$).

2. Method according to claim 1 or 2 (sic), characterised in that the frequency-measuring device is a digital frequency-measuring device.

3. Method according to claim 2, characterised in that

   - in the case of the digital frequency-measuring device (8), a linear-phase, non-recursive digital filter with symmetrical distribution of its filter coefficients, to which filter is applied the electrical signal, is constructed as an all-pass filter,
   - a further linear-phase, non-recursive digital filter with symmetrical distribution of its filter coefficients, to which filter is likewise applied the electrical signal, is constructed as a low-pass filter, in such a way that its transfer function at a predetermined frequency of the electrical signal has the value One,
   - a switch unit is arranged downstream of the all-pass filter, which switch unit

     - contains in a branch, on the input side, a linear-phase transverse filter with symmetrical distribution of its filter coefficients, a delay element downstream thereof and a downstream multiplier, and
     - in a branch which is parallel to the one branch contains, on the input side, a further linear-phase transverse filter with asymmetrical distribution of its filter coefficients and a value One of its transfer function at the predetermined frequency, a further delay element downstream thereof and a downstream further multiplier, with

       - the one multiplier also being connected, on the input side, to an output of the further transverse filter and the further multiplier also being connected to the output of the one transverse filter, and - containing a difference former, the inputs of which are connected to the outputs of the multipliers,

- arranged downstream of the low-pass filter is a switching device, the construction of which is identical to that of the switch unit, and
- the outputs of the difference former of the switch unit and of the switching device are connected to a quotient former, downstream of which is a root extractor, and
- connected to the root extractor is an inverse function former.

## Revendications

1. Procédé numérique de détermination d'une grandeur de mesure à partir d'un signal électrique (u) de fréquence nominale prescrite, dans lequel

- on échantillonne le signal électrique (u) dans un dispositif (2) d'échantillonnage en obtenant des valeurs d'échantillonnage à une fréquence d'échantillonnage ($f_A$), qui est produite au moyen d'une horloge (9) et qui correspond N fois la fréquence nominale du signal électrique (u),
- on convertit les valeurs échantillonnées dans un convertisseur analogique-numérique (1) en valeurs numériques et
- on obtient à partir des valeurs numériques la grandeur de mesure dans un dispositif (5) d'exploitation,

caractérisé en ce que
on détermine une valeur de mesure ($f_{Nréel}$) qui correspond à la fréquence instantanée du signal électrique (u), par un dispositif (8) de mesure de fréquence,

- on multiplie la valeur de mesure ($f_{Nréel}$) par le facteur (N) en produisant une valeur de mesure calculée ($f_{A,consigne}$),
- on forme dans un dispositif (11) de formation de quotient, une grandeur intermédiaire correspondant au quotient de la fréquence de cadence ($f_Q$) de l'horloge (9) et de la valeur de mesure calculée ($f_{A,consigne}$) et
- on règle par la grandeur intermédiaire (N) le rapport de division d'un diviseur (12) de fréquence disposé entre l'horloge (9) et l'entrée de cadence du convertisseur (1) analogique-numérique, de telle sorte que la fréquence ($f_A$) correspondant à la valeur de mesure calculée ($f_{A,consigne}$) soit envoyée à l'entrée de cadence,
- une modification du rapport de division étant effectuée au plus tôt après l'écoulement de quelques périodes du signal électrique ($u_k$).

2. Procédé suivant la revendication 1 ou 2, caractérisé en ce que

- le dispositif de mesure de fréquence est un dispositif de mesure de fréquence numérique.

3. Procédé suivant la revendication 2, caractérisé en ce que

- dans le dispositif (8) de mesure de fréquence numérique, un filtre numérique non récursif à phase linéaire, qui est chargé par le signal électrique et dont les coefficients de filtre sont répartis symétriquement, est sous forme de filtre passe-tout,
- un filtre numérique supplémentaire non récursif à phase linéaire , qui est chargé également par le signal électrique et dont les coefficients de filtre sont répartis symétriquement est sous forme de filtre passe-bas, de telle sorte que sa fonction de transfert ait la valeur un pour une fréquence prescrite du signal électrique,
- il est disposé en aval du filtre passe-tout une unité d'interruption, qui

  - comprend dans une branche, du côté entrée, un filtre transversal à phase linéaire dont les coefficients de filtre sont répartis symétriquement, un élément de retardement branché en aval de celui-ci et un multiplicateur disposé en aval et
  - dans une branche parallèle à la première branche, du côté entrée, un filtre transversal supplémentaire à phase linéaire, dont les coefficients de filtre sont répartis symétriquement et dont la fonction de transfert a une valeur un à la fréquence prescrite, un élément de retardement supplémentaire branché en aval de celui-ci et un multiplicateur supplémentaire disposé en aval,

    - le premier multiplicateur étant relié du côté entrée également à une sortie du filtre transversal supplémentaire et le multiplicateur supplémentaire étant également relié à la sortie du premier filtre transversal, et
    - l'unité d'interruption comprend un dispositif de formation de différence, qui est relié par ses entrées aux sorties des multiplicateurs,

  - un dispositif d'interruption de structure identique à celle de l'unité d'interruption étant disposé en aval du filtre passe-bas,

  - les sorties des dispositifs de formation de différence de l'unité d'interruption et du dispositif d'interruption étant reliées à un dispositif de formation de quotient, en aval duquel est disposé un dispositif de formation de racine carrée, et

- il est connecté au dispositif de formation de racine carrée un dispositif de formation de fonction inverse.